Europäisches Patentamt

European Patent Office

Office européen des brevets

(11) Publication number: **0 050 461**
**B1**

# EUROPEAN PATENT SPECIFICATION

(45) Date of publication of patent specification: **04.02.87**

(51) Int. Cl.⁴: **H 03 M 1/24**

(21) Application number: **81304738.8**

(22) Date of filing: **12.10.81**

(54) **Encoder for machine control.**

(30) Priority: **15.10.80 CA 362421**

(43) Date of publication of application:
**28.04.82 Bulletin 82/17**

(45) Publication of the grant of the patent:
**04.02.87 Bulletin 87/06**

(84) Designated Contracting States:
**AT CH DE FR GB IT LI NL SE**

(56) References cited:
**DE-C- 821 561**
**US-A-1 500 579**
**US-A-3 693 024**

(73) Proprietor: **Gergek, Franc**
**1905-2600 Don Mills Road**
**Willowdale Ontario, M2J 3B4 (CA)**

(72) Inventor: **Gergek, Franc**
**1905-2600 Don Mills Road**
**Willowdale Ontario, M2J 3B4 (CA)**

(74) Representative: **Newens, Leonard Eric et al**
**F.J. CLEVELAND & COMPANY 40/43 Chancery Lane**
**London WC2A 1JQ (GB)**

Courier Press, Leamington Spa, England.

## Description

This invention relates to an encoder assembly for an apparatus having a rotatable control shaft. The movements of a rotating optical disc of the assembly, mounted on the shaft, is sensed by photoelectric cell means whose signals are interpreted and applied to controlling the rotation of the shaft.

A known encoder assembly is summarised in the pre-characterising portion of claim 1 and is known from US—A—3 693 024. In US—A—3693024 it is known to have an encoder disc mounted on a control shaft and having a plurality of clear and opaque segments for encoding an incident light beam. The encoding disc is mounted onto a gear assembly so as to rotate at a reduced speed with respect to the control shaft. A further encoder disc is also mounted on the control shaft to rotate at the same speed as the control shaft.

The present invention has specific utility in connection with the control of paper cutting apparatus, for example, as shown in US—A—4 331 050, the disclosure of which is hereby incorporated by reference. As a basis for describing the present invention, the essential features of the paper cutting apparatus of this prior art will be described. The paper cutting machine has a table for supporting a pile of sheets to be cut, cutting means and means for operating it. A backstop is mounted for movement along the table so as to position and advance the pile. There is drive means for moving the backstop along the table in either direction including a worm shaft and signalling means made up as follows. An optical disc is mounted on the worm shaft for rotation with it. The disc is provided with a regular series of radial stripes of predetermined width and spacing. A pair of photosensors is spaced-apart a predetermined distance about the disc whereby there are produced, as the disc rotates in either direction, wave forms corresponding to the stripes. A controller is electrically connected to the photosensors and the apparatus includes computer mechanism which converts the wave forms into distances corresponding to the travel of the backstop. Preferably the signalling means is provided with a vernier arrangement which includes an additional marking on the disc and a photosensor for sensing that marking. As movement of the backgauge is initiated, the controller moves it back until it is stopped by its own control. The controller presets, roughly, the position of the backgauge. After this rough setting, the controller moves the backgauge forward until the photosensor senses the vernier marking and this signifies to the controller the exact position of the backgauge.

It also is known from DE—C—821 561 to have an instrument casing which is split to allow simple mounting of the instrument parts. The instrument is a speedometer and includes an aperture for receiving a speedometer cable.

In summary, the prior art provides an encoder assembly encoding disc for attachment to and for rotation with a rotatable control shaft of an apparatus, said encoding disc including a plurality of openings for photoelectric sensing. The present invention includes an encoder assembly useful in apparatus of the aforementioned type and is summarized in the characterising portion of claim 1. Thus, a pair of companion half discs can be mounted against the shaft so that when they are connected together they provide a complete disc surrounding the shaft. Accordingly, the disc can be mounted on a control shaft from the side without having to dismount the shaft or any other parts of the apparatus. Each half disc can be provided with a signalling area which combines with that of the other half disc to form, on the assembled disc, a signalling track which can be sensed by appropriate sensing means, usually photoelectric means.

Preferably, the mounting means comprises a pair of semi-annular hub elements each made up of a solid, substantially arcuate body having a semi-cylindrical shaft engaging surface and a transverse mounting surface, each segment comprising an arcuate plate secured to a said mounting surface and being provided with openings for photoelectric sensing.

Conveniently a pair of spaced-apart circuit boards are mounted within one shell substantially parallel to the sidewalls and adjacent to the connecting wall. One of the circuit boards can carry photocell means and other light emitting means.

Dust-stripping is preferably provided to protrude beyond the recesses of the shells to close the gap between them and the shaft. Preferably, one of the shells is also provided with dust-stripping protruding beyond the edge abutting with the other shell to provide a dust-tight shield between the respective shells.

The mounting procedure is as follows. One half of the encoder casing, provided with the light source and photocells is placed in operative position against the shaft and is connected in fixed position to the frame of the machine. Then, the two halves of the encoder disc assembly are brought together around the shaft within the casing and secured in place, the encoder disc being adjusted to the proper radial position on the shaft vis-a-vis the light source and photocells. Once this is accomplished, the other side of the casing is brought into place about the shaft to abut the previously placed half of the casing and the two halves secured together so the completed casing forms an entire enclosure about the working parts of the device.

The invention, as outlined, will now be described more specifically by reference to the accompanying drawings, which illustrate preferred embodiments, and in which:

FIG. 1 is a perspective view of a pile of sheets ready to be cut;

FIG. 2 is a plan view of the pile showing the top sheet;

FIG. 3 is a front elevation of a cutting apparatus equipped according to the invention;

FIG. 4 is a front elevation of the apparatus of FIG. 3 showing the control panel;

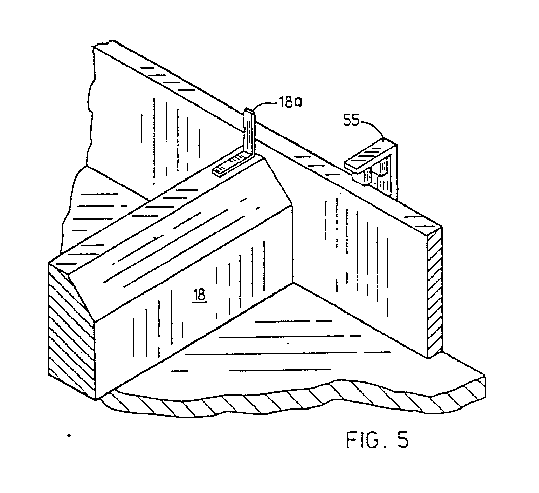

FIG. 5 is a perspective view illustrating the relationship between the backgauge and the position reference switch;

FIG. 6 is an exploded view showing the various parts of a preferred form of encoder assembly in relative position prior to mounting on a control shaft;

FIG. 7 is an end elevation of the shell carrying the circuit boards;

FIG. 8 is a front elevation of the encoder disc assembled on the shaft; and

FIG. 9 is a circuit diagram including the encoder cells and the light emitting means, and associated elements and associated circuitry.

Referring more particularly to the drawings, the nature of a cutting apparatus, according to the invention, will be explained in terms of its basic operation, as follows.

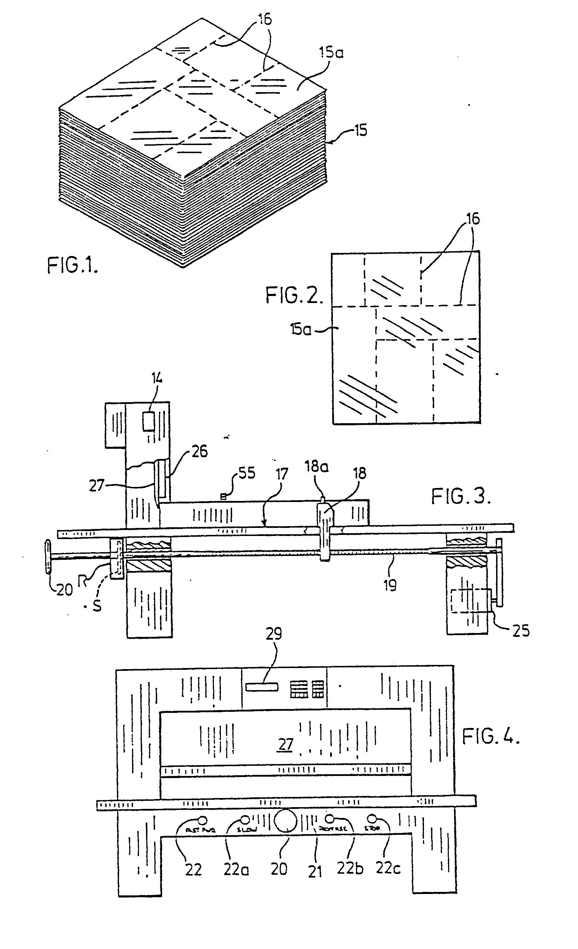

The printed stock from sheet fed presses comes in the form of a pile of sheets 15 (Fig. 1). Each sheet 15a is marked as at 16 to show the cuts required to divide the sheets into pages, coupons, etc. (Fig. 2).

The apparatus includes a table 17 on which the paper stock is laid up in the pile 15 to a few inches high and a backgauge 18 movable alongside the table by a worm gear 19, and having an upstanding reference marker 18a.

The gear 19 can be turned manually by a standby wheel 20 or automatically, according to the invention, by a motor mechanism controlled by push buttons in a panel 21 (Fig. 4). Normally, cutters have up to five separate push buttons 22, 22a, 22b, etc. (or a joystick with concealed switches) to provide fast forward, slow forward, reverse, sometimes slow reverse and stop.

The push buttons or switches are connected to a control box (not shown) through relays and other circuitry which may be of a conventional nature which, in turn, governs the direction and speed of the motor 25 (Fig. 3).

Above the table 17 there is a clamp 26 (Fig. 3) which presses the paper stock tightly down during the cutting and guillotine 27 (Fig. 3) which comes down and cuts the stock.

The cutting procedure is as follows. The backgauge 18 is moved to the first cutting position. The paper stock pile 15 is laid on the table and pushed firmly against the backgauge 18. Through a foot pedal or other means, the driving mechanism is activated and the clamp 26 squeezes the paper stock down. The display 29 (Fig. 4) displays the position of the backgauge 18.

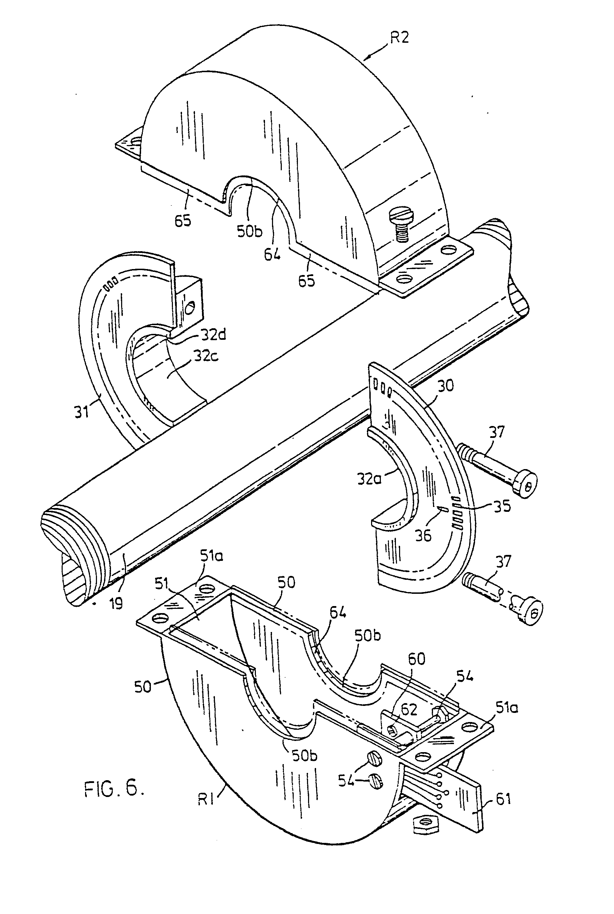

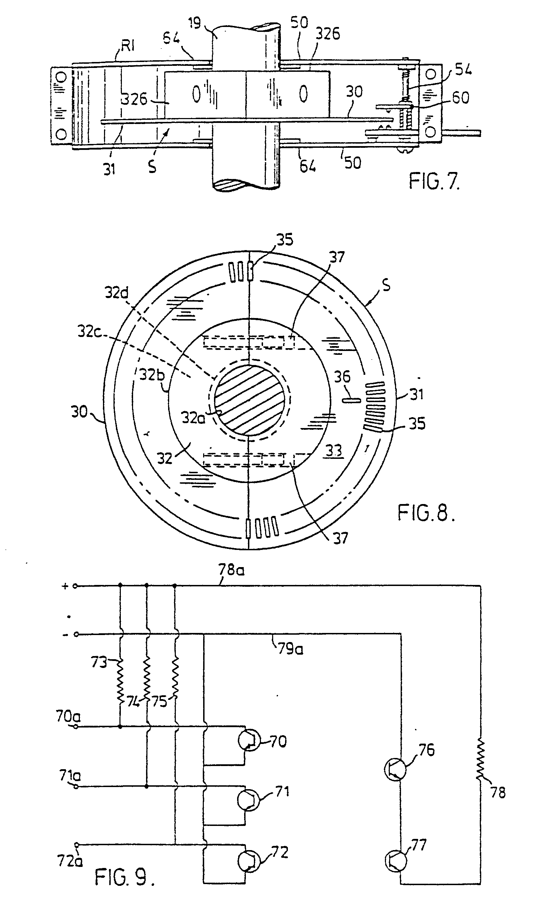

As in the prior application, the optical signalling disc assembly S (Figure 8) is fixedly mounted on the worm shaft 19. In accordance with the present invention, this assembly is made up of arcuate complementary plates 30 and 31 (Figure 6), preferably of sheet metal and respectively mounted on hub segments 32 and 33, preferably of fiber. Each plate 30, 31, has an arcuate marginal track made up of a regular series of radial slots 35, and, spaced inwards from the track, a single slot 36. The hub segment 32, for example, has inner and outer axially extending faces 32a and 32b and adjoining end faces. The inner face 32a ends at a narrow flange 32d. The other hub is similar, as shown by like numerals.

The disc 30 is secured to the hub segment as follows. The plate 30 is juxtaposed and adhesively secured to an end face with its inner edge abutting the flange 32d. Screws 37 are provided to extend through openings in the segment 32 and into the segment 33 so that the segments 32 and 33 may be drawn together about the shaft 19 and clamped to it.

In accordance with the invention, the optical disc S, mounted on shaft 19, is enclosed within a protective casing R, mounted on the frame of the apparatus, which houses the photoelectric cells and light emitting means, which are responsive to the movements of the disc S.

The casing R is made up of similar companion sheet metal shells $R_1$ and $R_2$ which fit about the shaft 19. In the preferred form shown in Figs. 6 and 7, these shells are of generally circular contour. The shell $R_1$, for example, is made up of spaced-apart semi-circular sidewalls 50 and extending between them a bridging wall 51 having a connecting flange 51a extending outward at each end provided with holes connected to the companion flange of the shell $R_2$. Extending inward from the straight edge of each wall 50 is an arcuate recess 50b having a diameter sufficiently larger than that of the shaft 19 to leave a small clearance gap when the casing is mounted beside the shaft.

Extending between the walls 50, spaced slightly inward from the wall 51, are a pair of mounting bolts 54. Mounted on the bolts 54 are small spaced-apart parallel circuit boards 60 and 61 having holes through which the bolts 54 extend. A screw 62 extends through the other end of the board 60 to a wall 50 and a screw 63 from the board 61 to the other wall 50. Appropriate nuts and spacing members cooperate with the bolts to function, as shown, to engage the circuit boards and walls of the shell. The boards 60 and 61 are thus held firmly in place, relative to each other and to the shell $R_1$. The shell $R_2$ is of the same construction as the shell $R_1$.

Both shells $R_1$ and $R_2$ are provided with dust-stripping. For example, a shaped piece of felt 64 (shown in phantom lines in Fig. 6) is mounted on the inside of each wall 50, 50a and projects slightly beyond the margin of the wall and is adapted about the recess 50b to bridge the gap between the shell R and the shaft 19 and the straight edge so as to overlap the fissure between the abutting straight edges of the walls 50 and 50a to bar dust from entering between the shells $R_1$ and $R_2$.

The circuit board 61 mounts three photocells 70, 71 and 72 (Figure 9), connected to terminals 70a and 70b, and balancing resistors 73, 74 and 75. Circuit board 60 mounts two light emitting diodes 76 and 77 connected between terminals 76a and 77a and intervening current limiting resistor 78.

As shown in the circuit diagram of Figure 9, the diodes 76 and 77 and the resistor 78 are connected by circuit wiring 78a and 79a to the electrical supply terminals 78 and 79. One side of each photocell 70, 71 and 72 is connected to one of the terminals 70a, 71a and 72a leading to the microcomputer which controls the backgauge of the cutter, as described in the specification, and through a resistor 73, 74 and 75 to the positive supply line 78a.

Mounting

The encoder assembly is mounted on the apparatus as follows.

First, the shell $R_1$ is brought into position near the shaft 19 and is screwed to the brackets 80 fixed to the machine frame. Then, a segment of the disc S is manipulated into position within the casing R and next to the shaft 19 and the other disc segment is abutted against it about the shaft and the two segments loosely secured together. Then the disc S is rotated to its proper position relative to the photocells and clamped to the shaft 19 by tightening the screws 37.

An opaque patch is secured to the plate 30 to overlap the gap between the respective plates 30 and 31 at each side of the hub and placed radially so as to overlap the slot 36. The patch serves the dual function of screening the gap 38 from the slot 36, and, as sighting means, showing the width of the gap between the respective plates 30 and 31, to aid in adjusting the gaps at each side of the hub.

The device is now functional and it merely remains for the shell $R_2$ to be abutted against the shell $R_1$ and secured to it by screws through the overlapping flanges to complete the protective casing R. The casing R isolates the disc S, the photocells, and light emitting device from the surrounding atmosphere. This provides protection from dust which would otherwise accumulate and interfere with the operation of the device.

As will be evident to those skilled in the art, appropriate materials may be readily selected for the various parts. For example, the shells are preferably drawn from sheet metal, but could be molded from plastic material. The disc segments are desirably made of thin sheet metal punched to provide the sensing slots. Or, the disc assembly could be similar to that shown in the applicant's prior application. The hub elements may conveniently be made from resin impregnated fiberboard. The circuit boards may be made of any convenient insulating material, for example, fiberboard.

**Claims**

1. An encoder assembly comprising an encoding disc (S) for attachment to and for rotation with a rotatable shaft (19) and a casing (R) for said encoding disc, said encoding disc including a plurality of openings (35, 36) for modulating at least one light beam and said casing including light emitting means (76, 77) for providing at least one light beam and photocell means (70, 71, 72) for sensing the modulated light characterised by the disc comprising a pair of segments (30, 31) connectable together to close around an intermediate length of the shaft without access to the shaft ends, and mounting means (32, 37) for connecting the segments together to define a disc and attaching a disc to the shaft and by the casing comprising a pair of complementary shells (R1, R2) connectable together to both close around an intermediate length of the shaft without access to the shaft ends and enclose the disc attached within said length; each shell comprising a spaced apart side wall (50) having edges for abutting the walls of the other shell, and a connecting wall (51); each side wall having a central recess (50b) extending inward from said edges to form an opening to accommodate the shaft and provide a clearance gap therefor.

2. An encoder assembly as claimed in Claim 1 wherein the mounting means comprises a pair of semi-annular hub elements (32) each made up of a solid, substantially arcuate body having a semi-cylindrical shaft engaging surface and a transverse mounting surface, each segment comprising an arcuate plate secured to a said mounting surface and being provided with openings for photoelectric sensing.

3. An encoder assembly as claimed in Claim 2 wherein the respective transverse mounting surfaces have a narrow annular flange (32c) adjoining the shaft engaging surfaces and the respective arcuate plates have an edge abutting there respective flange.

4. An encoder assembly as claimed in Claim 1, 2 or 3 wherein there are spaced apart circuit boards (60, 61) mounted within one of the shells adjacent to the connecting wall (51) and the photo cell means are mounted on one board and the light emitting means on the other.

5. An encoder assembly as claimed in any preceding Claim wherein resilient dust stripping (64) is mounted on the inside of each shell wall to protrude from its recess (50b) for forming a seal between the wall and the shaft.

6. An encoder assembly as claimed in Claim 5 wherein one shell has the said dust stripping (64) mounted on its walls such that it protrudes beyond its edge to overlap the edge of the other shell to bar the entry of dust.

7. An encoder assembly as claimed in any preceding Claim wherein the side walls (50) of each shell are of overall semi-circular shape and the connecting wall (51) is arcuate.

8. An encoder assembly as claimed in any preceding Claim wherein each end of the connecting wall terminates in an outwardly extending flange (51a) for connection to a similar flange on the other shell.

9. Apparatus including a rotatable control shaft having an encoder assembly according to any one of the preceding Claims mounted thereon.

10. Apparatus as claimed in Claim 9 wherein the encoder assembly is mounted such that its rotatable shaft is the said control shaft.

## Revendications

1. Ensemble codeur comprenant un disque de codage (S) pour fixation sur, et rotation avec un arbre tournant (19) et un boîtier (R) pour ledit disque de codage, ledit disque de codage comprenant une pluralité d'ouvertures (35, 36) pour moduler au moins un faisceau de lumière, et ledit boîtier comprenant des moyens d'émission de lumière (76, 77) pour fournir au moins un faisceau de lumière et un dispositif de cellule photoélectrique (70, 71, 72) pour détecter la lumière modulée, caractérisé en ce que le disque comprend une paire de segments (30, 31) pouvant être reliés ensemble pour se fermer autour d'une longueur intermédiaire de l'arbre sans accéder aux extrémités de l'arbre, et des moyens de montage (32, 37) pour relier les segments ensemble en vue de définir un disque et de rattacher un disque à l'arbre, et en ce que le boîtier comprend une paire de coquilles complémentaires (R1, R2) pouvant être reliées ensemble pour renfermer toutes les deux une longueur intermédiaire de l'arbre sans accéder aux extrémités de l'arbre et renfermer le disque rattaché à l'intérieur de ladite longueur; chaque coquille comprenant une paroi latérale espacée (50) ayant des rebords pour s'appuyer contre les parois de l'autre coquille, et une paroi (51) de raccordement; chaque paroi latérale étant dotée d'un évidement central (50b) s'étendant vers l'intérieur à part desdits rebords pour constituer une ouverture où l'arbre vient se loger et assurer un dégagement pour ce dernier.

2. Ensemble codeur selon la revendication 1, caractérisé en ce que les moyens de montage comprennent une paire d'éléments moyeu (32), chacun d'eux étant constitué par un corps massif, essentiellement en forme d'arc ayant une surface semi-cylindrique se mettant en prise avec l'arbre et une surface de montage transversale, chaque segment comprenant une plaque en forme d'arc fixée à une dite surface de montage et étant doté d'ouvertures pour détection photo-électrique.

3. Ensemble codeur selon la revendication 2 caractérisé en ce que les surfaces de montage transversales respectives sont dotées d'une bride annulaire (32c) étroite avoisinant les surfaces se mettant en prise avec l'arbre, et les plaques en forme d'arc respectives ont un rebord s'appuyant contre leur bride respective.

4. Ensemble codeur selon les revendications 1, 2 ou 3, caractérisé en ce qu'il est prévu des plaques pour circuits espacées (60, 61) montées à l'intérieur d'une des coquilles avoisinant la paroi de connexion (51) et en ce que les moyens cellule photoélectrique sont montés sur une plaque, et le dispositif émetteur de lumière est monté sur l'autre.

5. Ensemble codeur selon l'une quelconque des revendications précédentes, caractérisé en ce qu'un ruban antipoussières (64) élastique est monté sur l'intérieur de chaque paroi de coquille pour dépasser de son évidement (50b) pour constituer un joint étanche entre la paroi et l'arbre.

6. Ensemble codeur selon la revendication 5, caractérisé en ce qu'une coquille a ledit ruban anti-poussières (64) monté sur ses parois de sorte qu'il dépasse au delà de son bord pour dépasser le bord de l'autre coquille pour faire obstacle à l'entrée des poussières.

7. Ensemble codeur selon l'une quelconque des revendications précédentes, caractérisé en ce que les parois (50) latérales de chaque coquille sont généralement d'une forme semi-circulaire et que le paroi de connexion (51) est en forme d'arc.

8. Ensemble codeur selon l'une quelconque des revendications précédentes, caractérisé en ce que chaque extrémité de la paroi de connexion se termine en une bride (51a) s'étendant vers l'extérieur pour raccordement à une bride analogue sur l'autre coquille.

9. Appareil comprenant un arbre de commande tournant doté d'un ensemble codeur selon l'une quelconque des revendications précédentes monté sur ledit arbre.

10. Appareil selon la revendication 9, caractérisé en ce quel'ensemble codeur est monté de telle sorte que son arbre tournant soit ledit arbre de commande.

## Patentansprüche

1. Eine Codiereinheit, enthaltend eine Codierscheibe (S), die an einer drehbaren Welle (19) befestigbar ist und mit dieser umläuft, und ein Gehäuse (R) für die Codierscheibe, wobei die Codierscheibe eine Merhrzahl von Löchern (35, 36) zur Modulation von wenigstens einem Lichtstrahl enthält und das Gehäuse lichtemittierende Mittel (76, 77) zur Erzeugung von wenigstens einem Lichtstrahl und Photozellmittel (70, 71, 72) zur Erfassung des modulierten Lichtes enthält, dadurch gekennzeichnet, daß

die Scheibe ein Paar von Segmenten (30, 31) enthält, die miteinander verbindbar sind, um eine Zwischenlänge der Welle ohne Zugang zu den Enden der Welle zu umschließen, und Befestigungsmittel (32, 37), welche die Segmente unter Ausbildung einer Scheibe miteinander verbinden und eine Scheibe an der Welle befestigen.

daß das Gehäuse ein Paar von komplementären Schalen (R1, R2) enthält, die miteinander verbindbar sind sowohl, um eine Zwischenlänge der Welle ohne Zugang zu den Enden der Welle zu umschließen, als auch, um die innerhalb dieser Länge befestigte Scheibe zu umschließen, wobei jede Schale eine getrennte Seitenwand (50) mit Kanten zur Anlage an den Wänden der anderen Schale und eine Verbindungswand (51) aufweist, und wobei jede Seitenwand eine zentrale Ausnehmung (50b) aufweist, die sich von den Kanten nach innen erstreckt, um eine Öffnung zur Aufnahme der Welle und zur Ausbildung eines Spielraumspaltes dafür zu formen.

2. Codiereinheit nach Anspruch 1, dadurch gekennzeichnet, daß die Befestigungsmittel ein Paar von halbringförmigen Nabenteilen (32) enthalten, die jeweils aus einem im wesentlichen bogenförmigen Vollkörper mit einer halbzylindrischen Wellenanlagefläche und einer quer verlaufenden Befestigungsfläche besteht, wobei jedes Segment eine bogenförmige Platte enthält, die an einer Befestigungsfläche befestigt und mit Öffnungen zum photoelektrischen Abtasten versehen ist.

3. Codiereinheit nach Anspruch 2, dadurch gekennzeichnet, daß die jeweiligen quer verlaufenden Befestigungsflächen mit einem engen Ringflansch (32c) versehen sind, der an die Wellenanlageflächen anschließt, und die jeweiligen bogenförmigen Platten eine Kante aufweisen, die an dem jeweiligen Flansch anliegt.

4. Codiereinheit nach Anspruch 1, 2 oder 3, dadurch gekennzeichnet, daß im Abstand voneinander angeordnete Leiterplatten (60, 61) innerhalb einer der Schalen neben der Verbindungswand (51) angebracht sind und die Photozellmittel an einer Platte und die lichtemittierenden Mittel an der anderen Platte angebracht sind.

5. Codiereinheit nach einem der vorhergehenden Ansprüche, dadurch gekennzeichnet, daß ein elastischer Staubabstreifer (64) an der Innenseite jeder Schalenwand angebracht ist und von deren Ausnehmung (50b) Ausbildung einer Dichtung zwischen der Wand und Welle vorsteht.

6. Codiereinheit nach Anspruch 5, dadurch gekennzeichnet, daß der Staubabstreifer (64) an den Wänden einer Schale so angebracht ist, daß er jenseits deren Kante vorsteht, um die Kante der anderen Schale zu überlappen und den Eintritt von Staub zu verhindern.

7. Codiereinheit nach einem der vorhergehenden Ansprüche, dadurch gekennzeichnet, daß die Seitenwände (50) jeder Schale allgemein halbkreisförmig sind und die Verbindungswand (51) bogenförmig ist.

8. Codiereinheit nach einem der vorhergehenden Ansprüche, dadurch gekennzeichnet, daß jedes Ende der Verbindungswand in einem sich nach außen erstreckenden Flansch (51a) zur Verbindung mit einem ähnlichen Flansch an der anderen Schale endet.

9. Vorrichtung mit einer drehbaren Steuerwelle und einer Codiereinheit nach einem der Vorhergehenden Ansprüche.

10. Vorrichtung nach Anspruch 9, dadurch gekennzeichnet, daß die Codiereinheit so angebracht ist, daß ihre drehbare Welle die besagte Steuerwelle ist.

FIG.1.

FIG.2.

FIG.3.

FIG.4.

FIG. 5

FIG. 6.

FIG.7.

FIG.8.

FIG.9.